# FASCICULE DE BREVET EUROPEEN

(11) **EP 3 203 511 B1**
(45) Date de publication et mention de la délivrance du brevet: **29.01.2020**
(21) Numéro de dépôt: 17153660.0
(22) Date de dépôt: 30.01.2017
(51) Int. Cl.: H01L 23/29, H01L 23/31, H01L 25/00, H01L 25/065

(54) **PROCEDE DE PROTECTION CONTRE L'HUMIDITE D'UN DISPOSITIF ELECTRONIQUE HYBRIDE**
VERFAHREN ZUM SCHUTZ EINER ELEKTRONISCHEN HYBRIDVORRICHTUNG VOR FEUCHTIGKEIT
METHOD FOR PROTECTING A HYBRID ELECTRONIC DEVICE AGAINST MOISTURE

(30) Priorité: 04.02.2016 FR 1650873
(43) Date de publication de la demande: 09.08.2017
(73) Titulaire: COMMISSARIAT À L'ÉNERGIE ATOMIQUE ET AUX ÉNERGIES ALTERNATIVES, 75015 Paris (FR); Thales, 92400 Courbevoie (FR)
(72) Inventeur: MARION, François, 38950 SAINT MARTIN LE VINOUX (FR); MAINDRON, Tony, 38000 GRENOBLE (FR)
(74) Mandataire: Cabinet Laurent & Charras

(56) Documents cités:
- EP-A1- 2 476 784
- US-A1- 2005 103 264
- US-A1- 2009 001 487
- US-A1- 2009 065 932
- US-A1- 2016 020 160
- TONY MAINDRON ET AL: "Investigation of Al2O3 barrier film properties made by atomic layer deposition onto fluorescent tris-(8-hydroxyquinoline) aluminium molecular films", THIN SOLID FILMS, vol. 548, 1 décembre 2013 (2013-12-01), pages 517-525, XP055294322, CH ISSN: 0040-6090, DOI: 10.1016/j.tsf.2013.08.092

## Description

### DOMAINE DE L'INVENTION

La présente invention a trait à la fiabilisation de connexions entre deux composants assemblés.

L'invention trouve plus particulièrement application dans l'assemblage de deux composants électroniques selon la technique dite « face contre face », mieux connue sous l'expression anglo-saxonne *« flip chip »,* qui réalise des interconnexions verticales entre les deux composants. L'invention trouve ainsi particulièrement application dans les assemblages dits « puce sur puce », « puce sur wafer » et « wafer sur wafer ». L'invention s'applique avantageusement aux dispositifs requérant des interconnexions de motifs métalliques à très petits pas, notamment pour la fabrication d'imageurs de très grandes dimensions et à très petits pas, comme par exemple les matrices de détection hétérogènes de grande taille comprenant un grand nombre de connexions, des matrices de détection sensibles à la température et hybridées à froid, ou encore des matrices de détection sensibles aux contraintes mécaniques. L'invention s'applique également avantageusement aux structures dites « 3D », qui comprennent un empilement de circuits constitués de matériaux différents et par conséquent sensibles aux contraintes thermiques. L'invention s'applique également particulièrement aux détecteurs à forte sensibilité, capables de détecter un nombre restreint de photons, notamment un photon unique.

L'invention s'applique également à l'hybridation à froid de composants.

### ETAT DE LA TECHNIQUE

Le document US 2009/065932 A1 divulgue un procédé de formation d'une couche protectrice d'alumine sur des structures d'interconnexions. La couche protectrice comporte des particules nanométriques. Un matériau d'enrobage peut être appliqué en plus.

La publication de TONY MAINDRON ET AL: "Investigation of Al2O3 barrier film properties made by atomic layer deposition onto fluorescent tris-(8-hydroxyquinoline) aluminium molecular films", THIN SOLID FILMS, vol. 548, 1 décembre 2013, pages 517-525 divulgue des films protecteurs en alumine applicables par dépôt de couches minces (ALD), les films protecteurs ayant une perméabilité à la vapeur d'eau inférieure à 10⁻³ g/m²/jour.

L'assemblage de deux composants électroniques par la technique dite *« flip chip »,* par exemple par thermocompression, consiste usuellement à former des billes de soudure électriquement conductrices sur une face d'un premier composant électronique et sur une face d'un second composant selon un motif de connexion prédéterminé. Le premier composant est alors reporté sur le second composant de manière à mettre en correspondance les billes respectives de soudure de ceux-ci, puis l'ensemble est pressé et chauffé. Les billes mises en contact se déforment et fondent pour former des interconnexions électriques perpendiculaires au plan principal des composants électroniques, généralement sous la forme d'une tranche.

Il est ainsi généralement obtenu un dispositif comportant deux composants électroniques séparés d'une distance comprise entre 1 micromètre et 10 micromètres, dont l'aire en regard est supérieure à 100 mm² (par exemple deux surfaces carrées de 10 millimètres de coté en regard l'une de l'autre). Usuellement, la densité surfacique d'interconnexions est comprise entre 10¹⁰/m² et 10¹²/m².

Un problème avec ce type d'assemblage est que les interconnexions verticales obtenues par l'hybridation sont sensibles aux contraintes thermiques, et ce d'autant plus que les premier et second composants sont constitués de matériaux différents. En effet, les composants présentent le plus souvent des coefficients d'expansion thermique différents, de sorte que sous l'effet d'une variation de température, les interconnexions sont soumises à un cisaillement qui les fragilise et les casse.

Afin d'accroître la fiabilité thermo-mécanique d'un ensemble hybridé et de fournir une protection des interconnexions contre l'environnement, il est généralement prévu de remplir l'espace séparant les deux composants par une couche de résine, connue sous le nom de résine « d'enrobage » ou d'« *underfill* », l'action de remplir cet espace étant connue sous le nom d' « *underfilling* ». Les forces de cisaillement sont ainsi réparties sur l'ensemble de la couche séparant les deux composants hybridés, et non plus uniquement sur les interconnexions, ces dernières étant donc protégées de manière efficace. On parle alors de « flip-chip enrobé ». On pourra par exemple se référer au document « Underfill material selection for flip chip technology » de Diana C. Chiang, Thesis (S.M.), Massachusetts Institute of Technology, Dept. of Materials Science and Engineering, 1998.

On connait deux techniques de remplissage du volume séparant les deux composants hybridés par des billes de soudure : la première est connue sous l'expression de *« fast flow* », et la seconde est connue sous l'expression de « *no-flow* ». Ces techniques sont par exemple décrites dans le document « Characterization of a No-Flow Underfill Encapsulant During the Solder Reflow Process », de C.P. Wong et al., Proceedings of the Electronic Components and Technoloy Conference, 1998, pages 1253-1259.

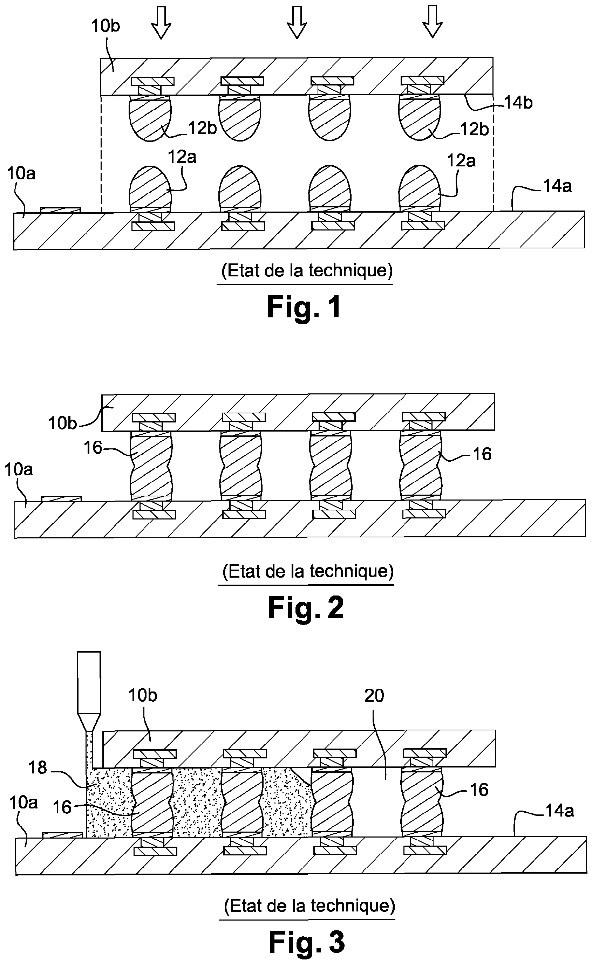

Un assemblage « flip-chip » suivi d'un enrobage selon la technique « *fast flow* » est à présent décrit en relation avec les figures 1 à 5.

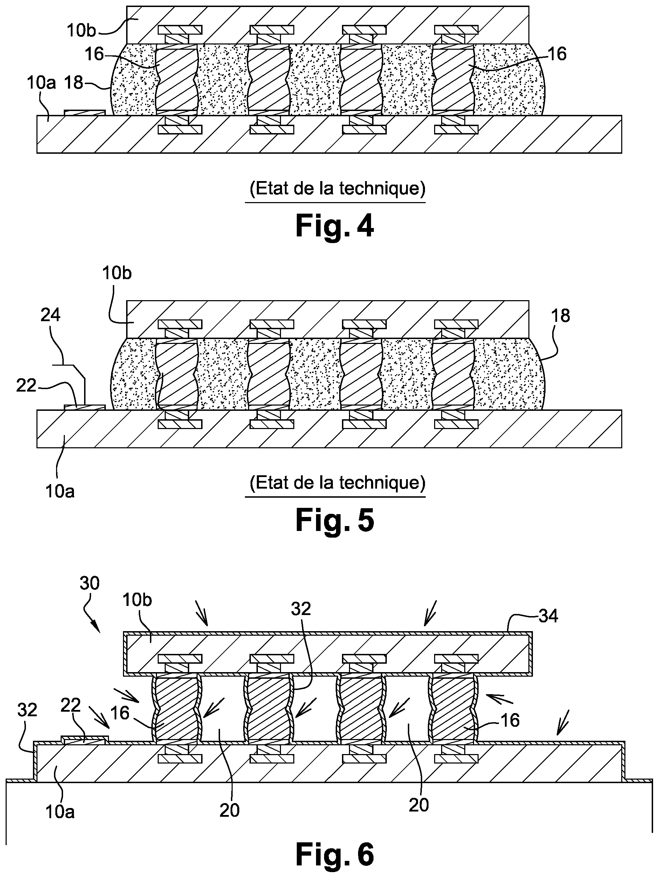

Dans une première étape (figure 1), un premier composant électronique **10a** muni de billes de soudure **12a** sur l'une de ses faces **14a,** est aligné avec un second composant électronique **10b,** également muni de billes de soudure **12b** sur l'une de ses faces **14b.** Une pression est exercée alors sur le second composant selon les flèches illustrées en élevant en outre la température de l'ensemble à une température supérieure ou égale à la température de fusion du métal constitutif des billes **12a, 12b.** Les billes **12a, 12b** se solidarisent alors les unes aux autres par thermocompression pour former des interconnections **16** (figure 2). Lors d'une étape suivante (figure 3), faisant usuellement suite à l'application d'un flux de désoxydation pour nettoyer les interconnexions **16,** une résine liquide **18,** électriquement isolante, est déposée à l'aide par un distributeur **20** sur la face **14a** du premier composant **10a.** La résine **18** migre alors par capillarité dans le volume **20** séparant les surfaces en regard des faces **14a, 14b** parallèles et finit par remplir totalement ce volume **20,** noyant ainsi les interconnexions électriques **16** (figure 4). La résine **18** est ensuite solidifiée, usuellement en appliquant un traitement thermique, ou « *curing* ». Une dernière étape de connexion du dispositif hybridé avec des éléments extérieurs (non représentés) est ensuite mise en œuvre (figure 5), par exemple en connectant des plages de connexion **22,** prévues à cet effet sur le premier composant **10a,** par des fils **24** (connexions dites « *wire-bonding* »).

Comme cela est connu en soi, la résine est un mélange d'une colle en tant que composant principal, par exemple une colle époxy, et d'un solvant qui permet de régler la viscosité de la résine et qui est évaporé lors du traitement thermique de la résine. Le mélange peut également comporter des agents durcisseur, notamment de polymérisation, par exemple un catalyseur, un photo-initiateur ou un thermo-initiateur, et/ou des agents de surface, par exemple du silane, qui augmente l'adhésion et la mouillabilité de la résine sur les surfaces des composants avec lesquelles elle rentre en contact, et/ou des particules pour régler le coefficient d'expansion thermique de la résine, usuellement désignées sous le terme de « *fillers* ».

Le premier problème posé par la technique « flip chip enrobée » est celui de la présence d'un polymère dans la résine de remplissage. Or, les polymères sont par nature « non hermétiques », c'est-à-dire qu'ils ne peuvent pas constituer sur le long terme une barrière contre l'humidité. En outre, leur efficacité contre l'humidité se dégrade fortement lorsque le dispositif subit des excursions thermiques importantes. Plus particulièrement, on observe une corrosion des interconnexions **16** en présence de l'humidité adsorbée. En effet, les interconnexions sont constituées en général d'un empilement complexe de matériaux métalliques (soudures, intermétalliques, métaux d'accroche, métaux barrière à la diffusion des soudures, etc...), de sorte que ces structures présentent des potentiels chimiques propices à une corrosion accélérée en présence d'humidité.

Par ailleurs, l'humidité implique le gonflement des résines d'enrobage après absorption d'humidité, ce qui induit des efforts mécaniques tendant à séparer les composants et conduisant à la rupture prématurée des interconnexions **16.**

Ainsi, le seul matériau d'enrobage de l'état de la technique ne permet pas une bonne résistance à des stress climatiques.

### EXPOSE DE L'INVENTION

L'invention est définie dans les revendications 1-3 ci-jointes.

Le but de la présente invention est de proposer une résistance à l'humidité accrue des interconnexions reliant deux composants reportés l'un sur l'autre, notamment dans le cadre d'une hybridation de type « flip-chip ».

A cet effet, l'invention a pour objet un procédé de protection contre l'humidité d'un dispositif comportant un premier et un second composants électroniques présentant respectivement deux surfaces en regard, lesdites surfaces :
- étant séparées par une distance non nulle et inférieure à 10 micromètres ;
- ayant une aire supérieure à 100 mm² ; et
- étant connectées par un ensemble d'éléments d'interconnexion électriques espacés les uns des autres par un espace vide de matière.

Selon l'invention, le procédé comporte l'application d'un dépôt de couches minces atomiques au dispositif de manière à former une couche de matériau minéral recouvrant au moins lesdits éléments d'interconnexion, la couche de matériau minéral ayant une perméabilité à la vapeur d'eau inférieure ou égale à 10⁻³ g/m²/jour.

Par matériau minéral, on entend au sens de l'invention les matériaux minéraux ou céramiques présentant des liaisons ioniques et ou des liaisons covalentes, notamment des matériaux inorganiques caractérisés par leur résistance mécanique et thermique (e.g. matériaux réfractaires) et leur bonne qualité de barrière à la vapeur d'eau. Parmi les matériaux minéraux utilisés comme imperméabilisant des interconnexions électriques, on peut citer les oxydes et/ou nitrure diélectrique, notamment ceux de formules TiO₂, ZrO₂, SiOₓ, SiNₓ, SiOₓN_{y}, ZnSe, ZnO, Sb₂O₃, les oxydes d'aluminium (e.g. Al₂O₃), et les oxydes transparents conducteurs (ou « OTC », e.g. l'oxyde d'indium-étain (« ITO ») ou l'oxyde de zinc dopés à l'aluminium (« AZO »)).

En d'autres termes, l'invention consiste à imperméabiliser les interconnexions de deux composants, par exemple assemblés selon une technique « flip-chip », cette imperméabilisation intervenant après l'hybridation mais avant l'enrobage par la résine. La surface des interconnexions est ainsi recouverte d'un matériau minéral, et par conséquent un matériau qui est à la fois non corrodable par l'eau et qui forme une barrière efficace à l'eau. En outre, le matériau imperméabilisant présente une formte adhérence avec les métaux. Enfin, les interconnexions n'étant pas corrodées, elles résistent donc mieux au gonflement résine induite par l'humidité.

En outre, il est considéré que les techniques classiques de dépôt en phase vapeur (e.g. PVD, CVD, mais également ALD) ne sont pas adaptées pour revêtir les interconnexions qui sont localisées dans un volume présentant un très grand rapport d'aspect. En effet, les interconnexions ont une densité surfacique si élevée qu'il n'existe pas de chemin « direct » depuis le bord du dispositif hybridé, i.e. le point d'entrée de la vapeur dans le volume entre les deux composants, et les interconnexions logées au cœur du dispositif. Notamment, pour chacune de ces interconnexions, il existe une multitude d'interconnexions qui la masquent de la phase vapeur. On note d'ailleurs que l'enrobage est toujours réalisé en phase liquide, utilisant la capillarité pour sa progression entre les deux composants. Notamment, il n'a pas été proposé dans l'état de la technique d'utiliser des techniques de dépôt en phase vapeur pour l'enrobage, alors même que ces techniques sont capables de déposer des épaisseurs de matériau de plusieurs dizaines de micromètres, et donc des épaisseurs bien supérieure à la distance usuelle entre les deux composants hybridés (de 1µm à 10 µm). Ceci signifie notamment qu'il est considéré que le volume entre les deux composants entrecoupés d'une multitudes d'interconnexions n'est accessible que par capillarité, les dépôts en phase vapeur étant au contraire utilisés pour déposer ou remplir des cavités vides de toute matière qui offrent des chemins directs à leurs parois pour la phase vapeur.

Or, les inventeurs sont parvenus à déposer une couche de matériau minéral sur des interconnexions logées dans un volume de rapport d'aspect supérieur ou égal à 10³ (cette valeur correspondant par exemple à des surfaces en regard qui sont carrées avec un côté de 10 millimètres et qui sont espacées de 10 micromètres) avec des densités surfaciques d'interconnexions supérieures à 10¹⁰/m².

Selon un mode de réalisation particulier, la couche de matériau de matériau minéral a une épaisseur comprise entre 10 nanomètres et 100 nanomètres, en particulier pour un matériau minéral constitué d'alumine (Al₂O₃). Une épaisseur de 10 nanomètre permet une bonne imperméabilisation des interconnexions. On constate en outre qu'au-delà de 100 nanomètre aucun gain notable en termes d'imperméabilité n'est obtenu.

Selon l'invention :
- l'application du dépôt de couches minces atomiques comprend le placement de la structure dans une enceinte et l'injection dans ladite enceinte de gaz réactifs pour la formation de la couche de matériau minéral ;
- et l'injection des gaz réactifs est réalisée sans pompage de l'enceinte.

En d'autres termes, lors du dépôt, l'enceinte n'est pas parcourue par un écoulement continu des précurseurs utilisés par le dépôt ALD, comme cela est classiquement le cas d'un dépôt ALD. En effet, dans ce mode de fonctionnement classique avec pompage, les espèces peuvent ne pas avoir le temps de diffuser partout dans les aspérités que représentent le volume inter-composants et les interconnexions. En outre, il peut également exister des écoulements de gaz perturbés par ces aspérités (génération de vortex par exemple), donnant naissance à une couche déposée non homogène, voire même à des portions non recouvertes. En stoppant le pompage, les espèces ont donc le temps de diffuser sans produire de perturbation gazeuse.

Selon un mode de réalisation optionnel, le procédé comprend le dépôt d'un matériau de remplissage remplissant complètement l'espace vide de matière séparant les surfaces en regard des deux composants, le dépôt du matériau de remplissage étant réalisé après le dépôt de la couche de matériau minéral sur les éléments d'interconnexion.

En mettant en œuvre le procédé décrit, on peut réaliser un dispositif comportant un premier et un second composants électroniques présentant respectivement deux surfaces en regard, lesdites surfaces :
- étant séparées par une distance non nulle et inférieure à 10 micromètres ;
- ayant une aire supérieure à 100 mm² ;
- étant connectées par un ensemble d'éléments d'interconnexion électriques distincts.

Ce dispositif comporte une couche de matériau minéral recouvrant au moins lesdits éléments d'interconnexion, la couche de matériau minéral ayant une perméabilité à la vapeur d'eau inférieure ou égale à 10⁻³ g/m²/jour.

Un tel dispositif est beaucoup plus fiable contre la corrosion de ces interconnexions et présente ainsi une durée de vie accrue.

Le matériau minéral est choisi dans le groupe constitué par les composés de formule SiOx, SiNₓ, SiOₓN_{y}, ZnSe, ZnO, Sb₂O₃, les oxydes d'aluminium et les oxydes transparents conducteurs (OTC).

La couche de matériau minéral a une épaisseur comprise entre 10 nanomètres et 100 nanomètres.

Le dispositif comprend un matériau de remplissage remplissant complètement l'espace séparant les surfaces en regard des deux composants.

### BREVE DESCRIPTION DES FIGURES

La présente invention sera mieux comprise à la lecture de la description qui va suivre, donnée uniquement à titre d'exemple, et réalisée en relation avec les dessins annexés, dans lesquels des références identiques désignent des éléments identiques, et dans lesquels :
- les figures 1 à 5 sont des vues schématiques en coupe illustrant un procédé de fabrication d'un dispositif hybridé par une technique « flip-chip » selon l'état de la technique, tel que discuté ci-avant ; et
- les figures 6 à 8 sont des vues schématiques en coupe illustrant un procédé de fabrication d'un dispositif hybridé par une technique « flip-chip » selon l'invention, comprenant une étape d'imperméabilisation des interconnexions électriques.

### DESCRIPTION DETAILLEE DE L'INVENTION

En se référant aux figures 6 à 8, un procédé de fabrication d'un dispositif **30** comprenant deux composants électroniques **10a, 10b,** hybridés et comportant des interconnexions électriques **16,** débute de manière similaire à l'état de la technique, tel que par exemple décrit en relation avec les figures 1 et 2. Ce dispositif comporte deux composants électroniques, par exemple séparés d'une distance comprise entre 1 micromètre et 10 micromètres, dont l'aire en regard est supérieure à 100 mm² (par exemple deux surfaces carrées de 10 millimètres de coté en regard l'une de l'autre), et dont la densité surfacique d'interconnexions est comprise entre 10¹⁰/m² et 10¹²/m².

Une fois l'hybridation terminée, et avant l'application d'un matériau d'enrobage **18,** une étape d'imperméabilisation des interconnexions électriques **16** par une couche minérale est mise en œuvre au moyen d'un dépôt « ALD ».

Comme cela est connu en soi, l'ALD est une technique de dépôt de couches atomiques qui consiste à exposer successivement une surface placée dans une enceinte, ou « chambre à réaction », à différents précurseurs chimiques, afin d'obtenir des couches ultra minces. Le dépôt d'une couche atomique se déroule usuellement en 4 étapes :
a) injection dans la chambre d'un premier précurseur gazeux entrainant la formation sur la surface d'une monocouche constituée d'espèces chimisorbées et d'autres physisorbées ;
b) purge de la chambre de réaction, par exemple au moyen d'un balayage par de l'azote ultra pur pour éliminer toutes espèces n'ayant pas réagi ainsi que d'éventuels sous-produits de réaction ;
c) injection dans la chambre d'un second précurseur gazeux entrainant la formation de la couche de matériau souhaité sur la surface ;
d) purge de la chambre pour éliminer les espèces n'ayant pas réagi et les éventuels sous-produits de réaction. Classiquement, un pompage de l'enceinte est mis en œuvre pendant l'injection des précurseurs afin de produire un écoulement de ces derniers dans l'enceinte.

De manière avantageuse, le dispositif **30** est placé dans l'enceinte, notamment sur un support **32,** et l'injection des précurseurs est réalisée sans pompage, de sorte que les précurseurs baignent le dispositif **30** et diffusent intégralement dans le volume **20** entre les composants **10a, 10b** sans provoquer de perturbation gazeuse. Il est ainsi obtenu une couche **34** déposée sur l'intégralité de la surface exposée du dispositif **30,** et donc sur les interconnexions **16** (figure 6).

La couche de matériau minéral déposée par ALD est avantageusement une couche électriquement isolante, notamment une couche de matériau de formule TiO₂, ZrO₂, SiOₓ, SiNₓ, SiOₓN_{y}, ZnSe, ZnO, Sb₂O₃, les oxydes d'aluminium (e.g. Al₂O₃) et les oxydes transparents conducteurs (ou « OTC », e.g. l'oxyde d'indium-étain (« ITO ») ou l'oxyde de zinc dopés à l'aluminium (« AZO »)), notamment d'une épaisseur comprise entre 10 nanomètres et 100 nanomètres. Il est ainsi obtenu une couche dont la perméabilité à la vapeur d'eau inférieure ou égale à 10⁻³ g/m²/jour.

De manière avantageuse, une couche d'Al₂O₃, de TiO₂ ou de ZrO₂ est déposée. Ces matériaux, outre leur propriété imperméabilisante, présente une bonne mouillabilité avec les résines usuellement utilisées pour le remplissage, et aide donc à la progression par capillarité de la résine.

Dans une première variante, la couche **34** est constituée d'un unique matériau.

Dans une seconde variante, la couche **34** est un multicouches de matériaux minéraux différents, appelés nanolaminés, ce qui permet de combiner différentes propriétés de perméabilité, ou de boucher des chemins de diffusion des gaz dans une couche par le dépôt d'une couche de matériau différent. Avantageusement, la couche **34** est un bicouche Al₂O₃/TiO₂ ou un bicouche Al₂O₃/ZrO₂. Une bicouche permet notamment de passiver la couche au contact des interconnexions (e.g. Al₂O₃) par un matériau stable à l'humidité.

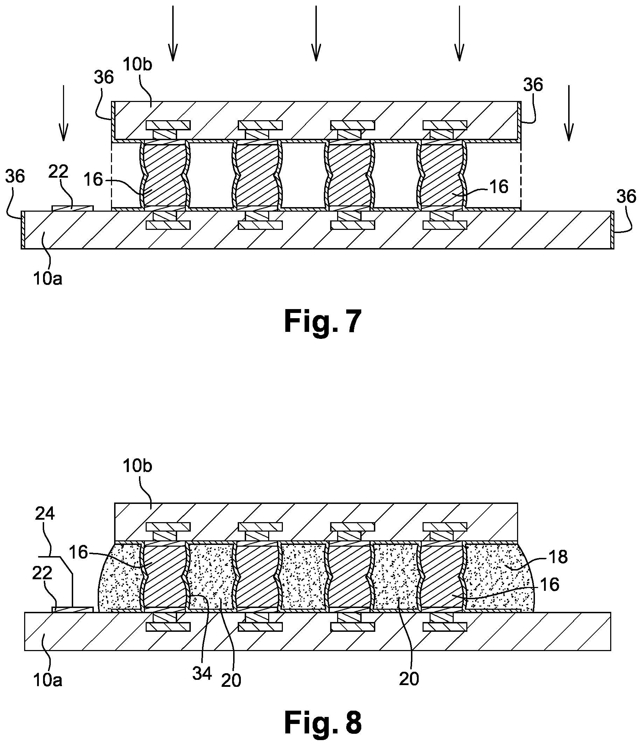

En raison du caractère isolant de la couche imperméable **34,** les plages de connexion **22** du dispositif ne sont pas accessibles à une connexion électrique, notamment par wire-bonding. Le procédé se poursuit donc par la libération d'au moins l'une de ces plages de connexion **22,** avantageusement par la mise en œuvre d'une attaque isotrope, de direction normale au plan principal du dispositif, tel qu'illustré par les flèches de la figure 7. Cette attaque isotrope a pour effet d'ôter les portions de couches imperméables sur la face supérieure du second composant **10b** et les portions de couche imperméable **34** du premier composant **10a** qui ne sont pas en regard du second composant **10b,** et par conséquent les portions de couche **34** recouvrant les plages de connexion **22.** L'attaque isotrope est par exemple un usinage ionique (bombardement par ions unidirectionnels), une attaque au plasma isotrope, etc. En cas de besoin, les bords latéraux **36** du dispositif sont également libérés, par exemple en inclinant le dispositif **30** lors de l'attaque isotrope, tout en évitant que l'attaque n'atteigne les interconnexions **16.**

Une fois l'imperméabilisation des interconnexions **16** réalisée, le procédé de fabrication se poursuit de manière classique par le remplissage du volume **20** inter-composant par de la résine **18** et la connexion des plages **22,** par exemple tel que décrit en relation avec les figures 3 à 5. Il est ainsi obtenu un dispositif hybridé, dont les interconnexions sont enrobées par une couche imperméable **34** et dont le volume **20** entre les composants électroniques **10a** et **10b** est rempli de résine **18** (figure 8).

A titre d'exemple numérique, le procédé d'imperméabilisation a été testé sur l'afficheur d'un projecteur comportant une matrice de 1746×1000 pixels (et donc autant d'interconnexions) au pas de 10 micromètres, hybridée sur une matrice de commande CMOS munie de micro-tubes enrobés d'une couche d'or et respectivement insérés dans les billes d'indium de la matrice de pixels, les interconnexions étant donc constituées de micro-tubes insérés dans des billes. La taille de la matrice active est ainsi de 17,46 mm par 10 mm et la matrice de pixels est espacée de la matrice de commande par une distance de 5 micromètres. Une telle hybridation est décrite par exemple dans les documents WO 2009/115686 et US 2011/0094789. Grâce à l'invention, une couche de 25 nanomètres d'Al₂O₃ a été déposée par ALD sur chacune des interconnexions, le procédé se terminant par l'enrobage par capillarité à l'aide d'une résine par exemple de l'« Epotek 353ND »© de la société Epoxy Technology Inc., USA.

A la vue de ce qui précède, on comprend que l'invention s'applique à tout type d'hybridation « flip-chip » (thermocompression de billes, insertion d'éléments mâles dans des éléments femelles, insertion d'éléments pleins ou creux dans des billes de plus faible ductilité, insertion à température ambiante ou non, etc...).

De même, l'invention s'applique à tout dispositif comportant deux composants en regard et reliés par des interconnexions, électriques ou non, que le dispositif ait été obtenu par hybridation « flip-chip » ou non.

De même, bien qu'il ait été décrit une étape finale de remplissage (« *underfilling* »), l'invention couvre également les dispositifs qui ne sont pas pourvus d'un tel enrobage.

## Revendications

1. Procédé de protection contre l'humidité d'un dispositif comportant un premier et un second composants électroniques (10a, 10b) présentant respectivement deux surfaces en regard, lesdites surfaces :
- étant séparées par une distance non nulle et inférieure à 10 micromètres ;
- ayant une aire supérieure à 100 mm² ;
- étant connectées par un ensemble d'éléments d'interconnexion électriques (16) espacés les uns des autres par un espace vide de matière, le procédé comportant l'application d'un dépôt de couches minces atomiques au dispositif de manière à former une couche (34) de matériau minéral recouvrant au moins lesdits éléments d'interconnexion, la couche de matériau minéral étant choisie dans le groupe constitué par les composés de formule TiO₂, ZrO₂, SiOₓ, SiNₓ, SiOₓN_{y}, ZnSe, ZnO, Sb₂O₃, les oxydes d'aluminium et les oxydes transparents conducteurs (OTC) ;
- et l'application du dépôt de couches minces atomiques comprenant le placement de la structure dans une enceinte et l'injection dans ladite enceinte de gaz réactifs pour la formation de la couche de matériau minéral ;
- et l'injection des gaz réactifs étant réalisée sans pompage de l'enceinte.

2. Procédé selon la revendication 1, dans lequel la couche de matériau minéral a une épaisseur comprise entre 10 nanomètres et 100 nanomètres.

3. Procédé selon l'une quelconque des revendications précédentes, comprenant en outre le dépôt d'un matériau de remplissage remplissant complètement l'espace vide de matière séparant les surfaces en regard des deux composants, le dépôt du matériau de remplissage étant réalisé après le dépôt de la couche de matériau minéral sur les éléments d'interconnexion.

## Patentansprüche

1. Verfahren zum Schutz einer Vorrichtung gegen Feuchtigkeit, mit einer ersten und einer zweiten elektronischen Komponente (10a, 10b) mit jeweils zwei gegenüberliegenden Oberflächen, wobei diese Oberflächen:
- durch einen Abstand ungleich Null und kleiner als 10 Mikrometer voneinander getrennt sind;
- eine Fläche von mehr als 100 mm² haben;
- durch einen Satz elektrischer Verbindungselemente (16) verbunden sind, die wiederum durch einen materialfreien Raum voneinander getrennt sind;
das Verfahren umfasst dabei das Aufbringen von dünnen, atomaren Schichten auf die Vorrichtung, so dass eine Schicht (34) aus mineralischem Material gebildet wird, die mindestens die Verbindungselemente bedeckt, wobei das Material der mineralischen Schicht ausgewählt wird aus der Gruppe der Verbindungen mit der Formel TiO₂ ZrO₂, SiOₓ, SiNₓ, SiOₓN_{y}, ZnSe, ZnO, Sb₂O₃, Aluminiumoxide sowie transparente, leitfähige Oxide (TCO);
- und das Aufbringen der dünnen, atomaren Schichten das Einsetzen der Struktur in eine Kammer umfasst sowie das Einblasen reaktiver Gase in diese Kammer, zur Bildung der mineralischen Materialschicht;
- und das Einblasen der reaktiven Gase ohne Auspumpen der Kammer erfolgt.

2. Verfahren nach Anspruch 1, bei dem die mineralische Materialschicht eine Dicke zwischen 10 Nanometern und 100 Nanometern hat.

3. Verfahren nach einem der vorstehenden Ansprüche, das außerdem die Ablagerung eines Füllmaterials umfasst, zum vollständigen Ausfüllen des materialfreien Raums, der die den beiden Bauteilen gegenüberliegenden Oberflächen trennt; die Ablagerung des Füllmaterials erfolgt dabei nach der Ablagerung der mineralischen Materialschicht auf den Verbindungselementen.

## Claims

1. A method of protecting against humidity a device comprising a first and a second electronic components (10a, 10b) respectively having two opposite surfaces, said surfaces:
- being separated by a non-zero distance shorter than 10 micrometers;
- having an area greater than 100 mm²;
- being connected by an assembly of electrical interconnection elements (16) spaced apart from one another by a space void of matter,
said method comprising
- applying a deposit of thin atomic layers onto the device to form a layer (34) of mineral material covering at least said interconnection elements, the layer of mineral material being selected from the group comprising the compounds of formula TiO₂, ZrO₂, SiOₓ, SiNₓ, SiOₓN_{y}, ZnSe, ZnO, Sb₂O₃, aluminum oxides, and transparent conductive oxides (TCO) ;
- applying the deposit of thin atomic layers comprising placing the structure in a chamber and injecting into said chamber reactant gases for the forming of the layer of mineral material, the injection of the reactant gases being carried out without pumping in the chamber.

2. The method of claim 1, wherein the layer of mineral material has a thickness in the range from 10 nanometers to 100 nanometers.

3. The method of any of the foregoing claims, further comprising depositing a filling material totally filling the space void of matter separating the opposite surfaces of the two components, the deposition of the filling material being carried out after the deposition of the layer of mineral material on the interconnection elements.
